# NOUVEAU FASCICULE DE BREVET EUROPEEN

(11) **EP 3 364 734 B2**
(45) Date de publication et mention de la décision concernant l'opposition: **23.11.2022**
(45) Mention de la délivrance du brevet: 12.08.2020
(21) Numéro de dépôt: 18157218.1
(22) Date de dépôt: 16.02.2018
(51) Int. Cl.: H05K 5/00, H05K 7/14

(54) **COFFRE AMELIORE POUR UN CONVERTISSEUR D'ALIMENTATION EN PUISSANCE ELECTRIQUE D'UN MOTEUR D'UN VEHICULE GUIDE**
VERBESSERTER KASTEN FÜR EINEN STROMWANDLER ZUR VERSORGUNG EINES MOTORS EINES GELENKTEN FAHRZEUGS MIT ELEKTRISCHER LEISTUNG
ENHANCED HOUSING FOR AN ELECTRIC POWER SUPPLY CONVERTER FOR AN ENGINE OF A GUIDED VEHICLE

(30) Priorité: 17.02.2017 FR 1751290
(43) Date de publication de la demande: 22.08.2018
(73) Titulaire: ALSTOM Transport Technologies, 93400 Saint-Ouen (FR)
(72) Inventeur: DELVAL, Damien, 59600 ASSEVENT (FR)
(74) Mandataire: Lavoix

(56) Documents cités:
- EP-A1- 2 816 716
- DE-A1-102013 202 236
- DE-U1- 7 628 374
- DE-U1-202015 105 357
- DE-U1-202015 105 896
- DE-U1-202016 104 380
- US-A1- 2001 030 881
- Harald Hepp: "FLIRT EMUs for Belarus", Railvolution, vol. 11, no. 4 6 September 2011 (2011-09-06), pages 60-69, Retrieved from the Internet: URL:https://library.e.abb.com/public/d3d79 c509dbdcb21c1257928003592ee/Railvolution04 -11-Traction-package-Belarus-Flirt.pdf
- Peter Dähler et al: "The compact converter", ABB Review, March 2006 (2006-03), pages 52-55, Retrieved from the Internet: URL:https://library.e.abb.com/public/326c8 2ccce4a958cc12571d900429285/52-55%203M651A _ENG72dpi.pdf
- ABB: "BORDLINE CC750 AC 15-25kV_M-700", ABB Switzerland Ltd, Retrieved from the Internet: URL:https://library.e.abb.com/public/79f9e e6bfdaf11e4c1257b130056e16a/PRS_BORDLINE%2 0CC750_AC_15-25kV_M_700.pdf
- Harald Hepp: "Eine maßgeschneiderte Lösung", ABB technik, vol. 2, February 2010 (2010-02), pages 60-65,
- ABB: "BORDLINE® CC750 DE", ABB Switzerland Ltd, 2012, Retrieved from the Internet: URL:https://library.e.abb.com/public/e4c72 03c24d0e5dcc1257b130056e 37f/PDS%20BORDLlNE%20CC750%20 DE_3BHS262330%20ZAB %20E07%20Rev%20A.pdf

## Description

La présente invention concerne un coffre pour un convertisseur d'alimentation en puissance électrique d'un moteur d'un véhicule guidé, comportant un cadre délimitant intérieurement un volume principal, propre à recevoir une électronique haute-tension, et un volume de passage, le cadre étant muni d'une ouverture donnant sur le volume de passage de manière à autoriser un accès, depuis l'extérieur du coffre, au volume principal, le coffre comprenant un capot amovible d'obturation de l'ouverture pour fermer le coffre.

La tendance générale est à l'intégration des différents composants électroniques constitutifs du convertisseur à l'intérieur d'un coffre placé à proximité immédiate du moteur électrique à alimenter, par exemple sous la caisse d'un véhicule guidé, en particulier un véhicule ferroviaire.

A ceci s'ajoute le fait que pour maximiser l'espace passager, les différents équipements du train sont déportés en toiture ou sous la caisse du véhicule ferroviaire de sorte que ces espaces sont encombrés et qu'il y a donc un besoin de réduction de l'encombrement stérique de chaque équipement individuellement.

Les documents EP 2 816 716 A1 et US 2001/030881 A1 divulguent respectivement un coffre du type précité comportant, en outre, une baie électronique propre à recevoir une électronique basse-tension de commande de l'électronique haute-tension, à laquelle l'électronique basse-tension est connectée par une gerbe de câbles électriques.

L'invention a donc pour but de répondre à ces problèmes, notamment en apportant une solution à la fois au problème de l'intégration des composants et à celui de la nécessaire compacité des coffres pour convertisseur d'alimentation en puissance électrique.

A cet effet, l'invention a pour objet un coffre selon les revendications annexées.

L'invention sera mieux comprise à la lecture de la description qui va suivre d'un mode de réalisation particulier, donné uniquement à titre d'exemple illustratif et sans caractère limitatif, cette description étant faite en se référant aux dessins annexés sur lesquels :
- la figure 1 est une vue de côté et en perspective d'un mode de réalisation préféré d'un coffre selon l'invention, dont le capot latéral est ouvert de manière notamment à faire apparaître la baie, qui se trouve sur cette figure dans sa première position ;
- la figure 2 est une représentation de côté et en perspective de la baie de la figure 1 ;
- la figure 3 est une représentation de côté et en perspective du coffre de la figure 1, le capot latéral étant ouvert et la baie se trouvant dans sa seconde position.

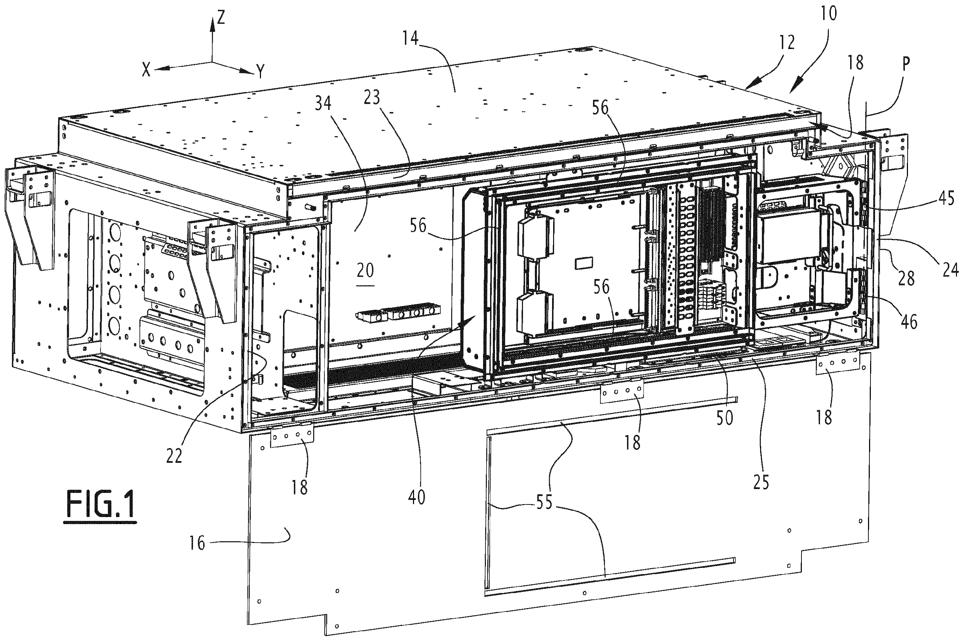

La figure 1 représente un coffre 10 selon un mode de réalisation préféré de l'invention.

Le coffre 10 est de préférence un coffre pour un convertisseur électrique propre à adapter une puissance électrique appliquée en entrée du convertisseur par une source pour délivrer en sortie une puissance électrique permettant l'alimentation d'au moins un moteur électrique, par exemple un moteur électrique synchrone d'un véhicule guidé, tel qu'un train, un métro, un tramway, etc.

Le coffre 10 est avantageusement installé à proximité immédiate du moteur qu'il doit alimenter. Il est par exemple fixé sous la caisse d'une voiture du véhicule guidé qu'il équipe.

Sur les figures, un trièdre orthogonal XYZ est représenté tel que l'axe X corresponde à l'axe longitudinal du véhicule guidé, l'axe Y, à un axe transversal du véhicule guidé, et l'axe Z, à un axe sensiblement vertical.

Le coffre 10 a une forme globalement parallélépipédique rectangle. Il est constitué d'un cadre 12 dont les différents montants délimitent des faces sensiblement rectangulaires. Par exemple, la face supérieure du coffre est recouverte par une plaque métallique 14.

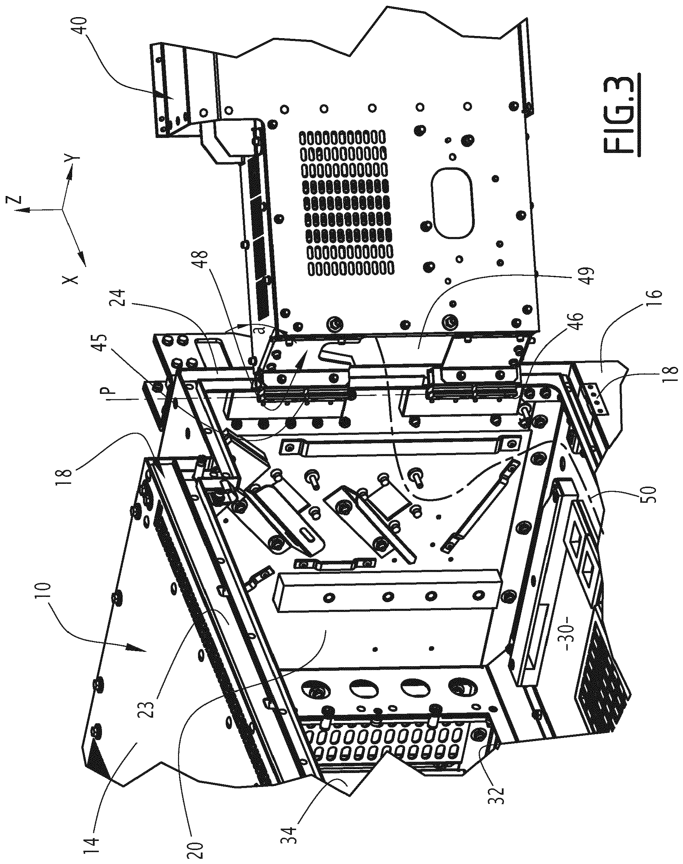

La face latérale gauche du coffre 10 est normalement recouverte d'une plaque métallique formant capot amovible 16. Sur les figures 1 et 3, le capot 16 est représenté dans sa position ouverte.

Les montants 22, 23, 24, et 25 du cadre 10 définissant la face latérale gauche délimitent une ouverture 20 permettant d'accéder au volume intérieur du coffre 10.

Le capot 16 est par exemple monté sur le montant inférieur 25 de l'ouverture 20 au moyen d'une pluralité de charnières 18 et maintenu en position fermée au moyen d'une pluralité de vis. Le capot 16 peut donc être ouvert par pivotement vers le bas, sur 180° par exemple.

Comme visible sur la figure 3, le cadre 18 du coffre délimite intérieurement une cavité subdivisée selon un plan vertical parallèle au plan vertical XZ un volume principal 32 et un volume de passage 30.

Le volume principal 32 est situé du côté de la face latérale droite du coffre, c'est-à-dire opposé à l'ouverture 20.

Le volume de passage 30 est situé entre le volume principal 32 et l'ouverture 20.

L'ouverture 20 donne ainsi accès sur le volume de passage 30 de manière à pouvoir accéder au volume principal 32 situé en retrait suivant l'axe transversal Y.

Le volume principal 30 est, dans notre exemple, propre à recevoir un châssis haute-tension 34, qui renferme les composants électroniques hautes-tensions du convertisseur. Dans le cas d'un convertisseur de puissance, il s'agit par exemple de dispositifs interrupteurs à semi-conducteur, comme des transistors, par exemple du type transistors bipolaire à grille isolée ou IGBT (de l'anglais « Insulated Gâte Bipolar Transistor »).

Avantageusement, ce châssis haute-tension 34 possède un profil dans le plan vertical XZ qui s'inscrit de manière ajustée à l'intérieur du profil selon le même plan vertical XZ du cadre 18 du coffre 10.

Ainsi, le châssis haute-tension 34 est propre à être inséré à l'intérieur du coffre 10 ou extrait hors du coffre 10 par coulissement selon l'axe transversal Y. Le châssis haute-tension 34 est poussé à travers l'ouverture 20 et le volume de passage 30 pour être logé, en position fonctionnelle, à l'intérieur du volume principal 30, auquel il correspond.

On voit ainsi que le volume de passage 30 et l'ouverture 20 doivent être totalement libres pour permettre l'installation ou l'extraction du châssis haute-tension 34 dans ou hors du coffre 10.

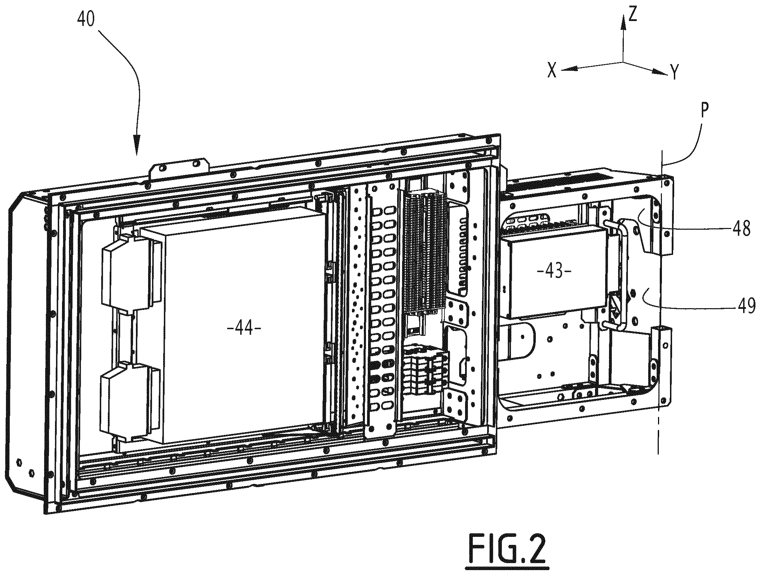

Le coffre 10 comporte en outre une baie électronique 40, de préférence destinée à recevoir un châssis basse-tension (représenté sur la figure 2 et portant la référence 44) regroupant les composants électroniques basses-tensions du convertisseur. Dans le cas d'un convertisseur de puissance, il s'agit par exemple de dispositifs de contrôle et de cadencement des dispositifs interrupteurs à semi-conducteur de l'électronique haute-tension.

Pour le fonctionnement du convertisseur, lors d'un usage normal ou en phase de maintenance, le châssis basse-tension 44 est connecté au châssis haute-tension 34 par une gerbe de câbles électriques. La gerbe est représentée en traits mixtes sur les figures 1 et 3 et référencée par le chiffre 50. Cette gerbe peut être torsadée sur elle-même de manière à former un toron.

La baie 40 est montée mobile sur le cadre 18 du coffre 10 pour pouvoir être déplacée entre deux positions extrêmes :
- une première position, représentée à la figure 1, dans laquelle la baie 40 est intégralement reçue dans le volume de passage 30 à l'intérieur du coffre 10, d'une manière autorisant la fermeture du capot 16.
- une seconde position, représentée à la figure 3, dans laquelle la baie 40 est située à l'extérieur du coffre 10 sans interférer avec les opérations d'insertion ou d'extraction du châssis haute-tension 34.

Comme cela sera présenté en détail ci-après, la baie 40 est propre à être déplacée d'une position à l'autre sans que les câbles 50 entre le châssis haute-tension 34 et le châssis basse-tension 44 ne soient déconnectés, soit volontairement soit involontairement (par exemple en cas d'application d'un effort de traction excessif au moment du déplacement de la baie).

Dans le mode de réalisation représenté sur les figures, la baie 40 est montée sur l'un des montants du cadre qui délimitent l'ouverture 20 de manière à pivoter autour d'un axe P parallèle à l'axe vertical Z. Pour ce faire, une charnière supérieure 45 et une charnière inférieure 46 sont utilisées pour coupler une paroi latérale arrière 48 de la baie 40 au montant vertical arrière 24 participant à la délimitation de l'ouverture 20. En variante, une autre face de la baie est couplée par un ensemble formant liaison pivot au montant de l'ouverture qui lui fait vis-à-vis. Dans encore une autre variante, d'autre moyens de liaison permettant le déplacement de la baie sont envisageables, tels qu'une liaison à double axe de pivotement par exemple. Le coffre étant soumis à des sollicitations mécaniques importantes au cours de son exploitation, le présent mode de réalisation présente une robustesse adaptée.

La baie 40 présente une forme extérieure pouvant être intégralement reçue à l'intérieur du volume de passage 30 sans interférer avec le châssis haute-tension 34 placé dans le volume principal 32 ni avec le capot 16 devant être rabattu pour fermer le coffre 10. La baie 40 présente également une forme extérieure devant pouvoir passer à travers l'ouverture 20 lors de son déplacement de la première position vers la seconde position ou inversement. Enfin, la baie 40 présente une forme extérieure n'interférant pas avec le volume de manipulation qui est le volume extérieur au coffre 10, mitoyen de l'ouverture 20 et nécessaire aux opérations de manipulation du châssis haute-tension 34 en insertion ou en extraction.

La baie 40 est constituée d'un boîtier sensiblement parallélépipédique, avantageusement ouvert du côté tourné vers l'ouverture 20 lorsque la baie 40 se trouve dans sa première position, afin de pouvoir accéder librement à l'intérieur du boîtier, par exemple pour y monter le châssis basse-tension 44.

Selon l'invention, le côté opposé au côté ouvert et qui est orienté vers le châssis haute-tension 34, et avantageusement les côtés inférieur et supérieur du boîtier de la baie 40, ainsi que le côté opposé au côté relié par des charnières au cadre, sont constituées d'une double paroi dont les cloisons sont séparées l'une de l'autre par une lame d'air. En ménageant des évents (56) de passage d'air entre l'extérieur de la baie 40 et la lame d'air, une circulation d'air peut être réalisée qui assure une ventilation passive de la baie 40 afin de réduire les échanges de chaleur entre l'électronique haute-tension, qui au cours de son fonctionnement dégage une chaleur importante, et l'électronique basse-tension de contrôle, par nature plus sensible aux conditions environnementales de fonctionnement.

Avantageusement, le capot 16 présente une pluralité de fentes 55 destinées à venir en regard des évents 56 lorsque le coffre est fermé pour autoriser une circulation d'air entre l'extérieur du coffre et la lame d'air de la double paroi de la baie.

Comme visible sur la figure 3, la paroi latérale arrière 48 de la baie 40 est couplée au montant 24 de l'ouverture 20 par une charnière inférieure 46 et une charnière supérieure 45 qui sont espacées l'une de l'autre de manière à réserver, entre ces charnières, un couloir pour la circulation de la gerbe de câbles 50. La paroi latérale arrière 48 de la baie 40 est munie, à mi-hauteur, d'une lumière 49 dont les dimensions sont adaptées pour recevoir la gerbe de câbles de manière à ce que celle-ci puisse passer depuis le volume de passage 30 à l'intérieur du boîtier constituant la baie 40.

A l'intérieur du boîtier, ces câbles sont par exemple connectés à un connecteur 43.

De préférence, l'axe P autour duquel pivote la baie 40 est situé légèrement à l'extérieur du coffre 10, au-delà du plan vertical parallèle au plan XZ dans lequel repose l'ouverture 20. Pour cela, les charnières 45 et 46 sont montées sur le montant 24 de manière à ce que leurs broches respectives, définissant l'axe P de pivotement, fassent saillie à l'écart de l'ouverture 20. De préférence, les charnières 45 et 46 font légèrement saillies à l'extérieur de l'ouverture.

Avantageusement, le boîtier de la baie 40 est chanfreiné de manière à ce que la paroi latérale arrière 48 de la baie 40 soit de biais par rapport à un plan moyen de la baie 40, qui, dans la première position de la baie, est sensiblement parallèle au plan vertical XZ. Ainsi, par exemple la paroi 48 fait un biseau a de 45°. Il n'est alors pas nécessaire de faire pivoter la baie 40 sur 180° pour l'écarter du volume de manipulation du châssis haute-tension 34 et libérer l'accès à l'ouverture 20, mais seulement de 135° (comme cela est représenté sur la figure 3). Il suffit de faire franchir à cette paroi verticale arrière 48 le plan vertical YZ d'une face arrière du coffre 10 pour être certain d'avoir un accès total au volume intérieur du coffre 10 et permettre l'insertion et/ou l'extraction du châssis haute-tension 34. De plus, le fait de n'avoir à faire pivoter la baie 40 que sur un arc réduit permet de limiter les efforts sur la gerbe de câbles 50 et donc de garantir le maintien d'une bonne connexion entre l'électronique haute-tension et l'électronique basse-tension à tout instant.

L'agencement du coffre selon l'invention permet ainsi d'optimiser le volume intérieur du coffre en utilisant le volume de passage pour recevoir l'électronique de contrôle du convertisseur lorsque le coffre est fermé, tout en conservant une totale accessibilité aux différents composants, haute et basse tension, lorsque le coffre est ouvert. De plus, les composants peuvent rester connectés, ce qui facilite les opérations de maintenance, en particulier la réalisation de tests électriques adaptés.

En faisant passer la gerbe de câbles 50 sensiblement par l'axe P autour duquel pivote la baie 40, la longueur nécessaire de câbles entre la connectique haute-tension et la connectique basse-tension est constante, quelle que soit la position de la baie entre ces positions extrêmes. En conséquence, aucun effort n'est appliqué sur ces câbles lors du pivotement de la baie 40. Les câbles ne sont donc pas déconnectés volontairement ou involontairement lors de l'ouverture ou de la fermeture de la baie. Ceci est particulièrement avantageux lors de la refermeture du coffre, puisque l'opérateur de maintenance sait que des câbles ne seront pas déconnectés lorsque la baie est rabattue dans la cavité du coffre.

Ceci constitue une solution avantageuse par rapport à celle qui consisterait à monter l'électronique de contrôle directement sur la face interne du capot amovible. En effet, par exemple lors de la fermeture du capot, il ne serait pas possible d'être certain que les composants électroniques montés sur celui-ci ne viennent pas interférer avec d'autres composants électroniques présents dans le coffre. L'électronique étant placée dans un plan hors de l'axe de pivotement du capot, l'ouverture du capot conduirait également à tendre et par conséquent à déconnecter les câbles de connexion : il faudrait donc déconnecter les câbles au cours de l'ouverture et donc complexifier les tests de maintenance ; ou prévoir une longueur supplémentaire de câbles qu'il faudrait alors loger à l'intérieur du volume de passage.

Ainsi, le coffre selon l'invention permet de loger l'électronique de contrôle à l'intérieur du coffre convertisseur accueillant l'électronique haute-tension, tout en conservant un accès simple et fonctionnel aux différents composants électroniques, facilitant ainsi la maintenance.

Il n'y a pas d'augmentation du volume total du coffre puisque c'est le volume de passage précédemment inutilisé ou utilisé pour des longueurs de câbles supplémentaires qui est employé.

Enfin, le coffre selon l'invention permet d'utiliser une longueur de câbles minimum entre l'électronique basse-tension et l'électronique haute-tension ce qui améliore la compatibilité électromagnétique de l'ensemble convertisseur.

Dans le mode de réalisation décrit ci-dessus en détail, le capot est relié au cadre, par exemple par des charnières. En variante, le capot est amovible pour être totalement séparable du cadre, ce qui facilite l'accès à l'intérieur du coffre lors des opérations de maintenance.

## Revendications

1. Coffre (10) pour un convertisseur d'alimentation en puissance électrique d'un moteur d'un véhicule guidé, comportant un cadre (18) délimitant intérieurement un volume principal (32), propre à recevoir une électronique haute-tension, et un volume de passage (30), le cadre (18) étant muni d'une ouverture (20) donnant sur le volume de passage (30) de manière à autoriser un accès, depuis l'extérieur du coffre (10), au volume principal (32), le coffre (10) comprenant un capot (16) amovible d'obturation de l'ouverture (20) pour fermer le coffre (10), le coffre comportant, en outre, une baie (40) électronique propre à recevoir une électronique basse-tension de commande de l'électronique haute-tension à laquelle l'électronique basse-tension est connectée par une gerbe (50) de câbles électriques,
la baie (40) étant montée mobile sur le cadre (18) du coffre (10) de manière à pouvoir être déplacée, à travers l'ouverture (20) et sans avoir à déconnecter la gerbe (50) de câbles électriques, entre des première et seconde positons telles que, dans la première position, la baie (40) est intégralement logée à l'intérieur du volume de passage (30) d'une manière permettant la fermeture du coffre (10) et, dans la seconde position, la baie (40) est intégralement à l'extérieur du coffre (10) d'une manière permettant un accès à l'ouverture (20) et au volume de passage (30) du coffre pour l'insertion, respectivement l'extraction, de l'électronique haute-tension à l'intérieur, respectivement hors, du coffre (10),
le coffre étant **caractérisé en ce que** la baie (40) comporte, au moins du côté orienté vers le volume principal (34) de réception de l'électronique haute-tension, une double paroi constituée de deux cloisons séparées l'une de l'autre par une lame d'air pour isoler thermiquement l'électronique basse-tension.

2. Coffre selon la revendication 1, dans lequel la baie (40) est montée pivotante sur un montant (24) délimitant l'ouverture (20).

3. Coffre selon la revendication 2, dans lequel un axe (P) de pivotement de la baie (40) est situé hors du coffre (10), au-delà du plan dans lequel repose l'ouverture (20).

4. Coffre selon la revendication 2 ou la revendication 3, dans lequel la baie (40) est couplée par une paroi latérale (48) au montant (24) délimitant l'ouverture (20) par au moins une charnière (45 et 46).

5. Coffre selon la revendication 4, dans lequel la paroi latérale (48) de la baie comporte une lumière (49) de passage de la gerbe (50) de câbles électriques.

6. Coffre selon l'une quelconque des revendications 4 à 5, dans lequel la paroi latérale (48) de la baie (40) est de biais pour limiter la distance angulaire entre les première et seconde positions.

7. Coffre selon l'une quelconque des revendications 1 à 6, dans lequel la gerbe (50) de câbles électriques est connectée entre l'électronique haute-tension logée à l'intérieur du volume principal (32) et l'électronique basse-tension logée à l'intérieur de la baie (40) à chaque instant du déplacement de la baie.

8. Coffre selon l'une quelconque des revendications 1 à 7, dans lequel la baie (40) est, au moins du côté orienté vers l'ouverture (20) lorsque la baie est dans sa première position, ouverte pour accéder à l'électronique basse-tension logée dans la baie.

9. Coffre selon l'une quelconque des revendications 1 à 8, dans lequel la baie (40) présente des évents (56) en communication fluidique avec la lame d'air de la double paroi de la baie (40), et le capot (16) présente une pluralité de fentes (55) destinées à venir en regard des évents lorsque le coffre est fermé pour autoriser une circulation d'air entre la double paroi de la baie et l'extérieur du coffre.

## Patentansprüche

1. Kasten (10) für einen Stromwandler zur Versorgung eines Motors eines gelenkten Fahrzeugs mit elektrischer Leistung, umfassend einen Rahmen (18), der ein Hauptvolumen (32) im Inneren begrenzt, das geeignet ist, eine Hochspannungselektronik zu empfangen, und ein Durchgangsvolumen (30), wobei der Rahmen (18) mit einer Öffnung (20) ausgestattet ist, die zum Durchgangsvolumen (30) gerichtet ist, um einen Zugang von der Außenseite des Kastens (10) zum Hauptvolumen (32) zu ermöglichen, wobei der Kasten (10) eine abnehmbare Haube (16) zur Abdichtung der Öffnung (20) umfasst, um den Kasten (10) zu schließen, wobei der Kasten außerdem einen elektronischen Baugruppenträger (40) umfasst, der geeignet ist, eine Niederspannungselektronik zur Steuerung der Hochspannungselektronik zu empfangen, mit der die Niederspannungselektronik durch Bündel (50) von elektrischen Kabeln verbunden ist,
wobei der Baugruppenträger (40) beweglich auf den Rahmen (18) des Kastens (10) montiert ist, um durch die Öffnung (20), und ohne das Bündel (50) von elektrischen Kabeln trennen zu müssen, zwischen einer ersten und zweiten Position verschoben werden zu können, so dass, in der ersten Position der Baugruppenträger (40) im Inneren des Durchgangsvolumens (30) auf eine Weise vollständig aufgenommen ist, die den Verschluss des Kastens (10) ermöglicht, und in der zweiten Position sich der Baugruppenträger (40) vollständig auf eine Weise außerhalb des Kastens (10) befindet, die einen Zugriff auf die Öffnung (20) und auf das Durchgangsvolumen (30) des Kastens ermöglicht, um die Hochspannungselektronik in das Innere des des Kastens (10) einzuführen bzw. daraus zu entnehmen,
wobei der Kasten **dadurch gekennzeichnet ist, dass** der Baugruppenträger (40), mindestens auf der Seite, die zum Hauptvolumen (34) zur Aufnahme der Hochspannungselektronik hin ausgerichtet ist, eine doppelte Wand umfasst, die aus zwei Trennwänden besteht, die voneinander durch einen Luftzwischenraum getrennt sind, um die Niederspannungselektronik thermisch zu isolieren.

2. Kasten nach Anspruch 1, wobei der Baugruppenträger (40) schwenkend auf einem Pfosten (24) montiert ist, der die Öffnung (20) begrenzt.

3. Kasten nach Anspruch 2, wobei eine Schwenkachse (P) des Baugruppenträgers (40) außerhalb des Kastens (10), über die Ebene hinaus, in der die Öffnung (20) liegt, angeordnet ist.

4. Kasten nach Anspruch 2 oder Anspruch 3, wobei der Baugruppenträger (40) durch eine seitliche Wand (48) an den Pfosten (24), der die Öffnung (20) begrenzt, durch mindestens ein Scharnier (45 und 46) gekoppelt ist.

5. Kasten nach Anspruch 4, wobei die seitliche Wand (48) des Baugruppenträgers (48) eine Durchgangsöffnung (49) des Bündels (50) von elektrischen Kabeln umfasst.

6. Kasten nach einem der Ansprüche 4 bis 5, wobei die seitliche Wand (48) des Baugruppenträgers (40) schräg ist, um den Winkelabstand zwischen der ersten und zweiten Position zu begrenzen.

7. Kasten nach einem der Ansprüche 1 bis 6, wobei das Bündel (50) von elektrischen Kabeln zwischen der Hochspannungselektronik, die im Inneren des Hauptvolumens (32) aufgenommen ist, und der Niederspannungselektronik, die im Inneren des Baugruppenträgers (40) aufgenommen ist, in jedem Moment der Verschiebung des Baugruppenträgers verbunden ist.

8. Kasten nach einem der Ansprüche 1 bis 7, wobei der Baugruppenträger (40), mindestens auf der Seite, die zur Öffnung (20) hin ausgerichtet ist, wenn sich der Baugruppenträger in seiner ersten Position befindet, offen ist, um auf die Niederspannungselektronik zugreifen zu können, die sich im Baugruppenträger befinet.

9. Kasten nach einem der Ansprüche 1 bis 8, wobei der Baugruppenträger (40) Entlüftungen (56) aufweist, die in fludischer Kommunikation mit dem Luftzwischenraum der doppelten Wand des Baugruppenträgers (40) sind, und die Haube (16) eine Vielzahl von Schlitzen (55) aufweist, die ausgelegt sind, um gegenüber den Entlüftungen zu liegen, wenn der Kasten geschlossen ist, um eine Zirkulierung von Luft zwischen der doppelten Wand des Baugruppenträgers und der Außenseite des Kastens zu ermöglichen.

## Claims

1. A housing (10) for an electric power supply converter of an engine of a guided vehicle, comprising a frame (18) inwardly delimiting a main volume (32), able to receive high-voltage electronics, and a passage volume (30), the frame (18) being provided with an opening (20) onto the passage volume (30) so as to allow access, from outside the housing (10), to the main volume (32), the housing (10) comprising a removable cover (16) closing off the opening (20) to close the housing (10), the housing further comprising an electronic bay (40) able to receive low-voltage electronics for controlling the high-voltage electronics to which the low-voltage electronics are connected through a stack (50) of electrical cables,
the bay (40) being movably mounted on the frame (18) of the housing (10) so as to be able to be moved, through the opening (20) and without having to disconnect the stack (50) of electrical cables, between first and second positions such that, in the first position, the bay (40) is completely housed inside the passage volume (30) in a manner allowing the housing (10) to be closed, and in the second position, the bay (40) is completely outside the housing (10) in a manner allowing access to the opening (20) and the passage volume (30) of the housing for the insertion, respectively the removal, of the high-voltage electronics inside, respectively outside, the housing (10),
the housing being **characterized in that** the bay (40) includes, at least on the side oriented toward the main volume (34) for receiving the high-voltage electronics, a double wall made up of two partitions separated from one another by an air gap for thermal insulation of the low-voltage electronics.

2. The housing according to claim 1, wherein the bay (40) is mounted pivoting on an upright (24) delimiting the opening (20).

3. The housing according to claim 2, wherein a pivot axis (P) of the bay (40) is located outside the housing (10), beyond the plane in which the opening (20) rests.

4. The housing according to claim 2 or claim 3, wherein the bay (40) is coupled by a lateral wall (48) to the upright (24) delimiting the opening (20) by at least one hinge (45 and 46).

5. The housing according to claim 4, wherein the lateral wall (48) of the bay includes a window (49) for the passage of the stack (50) of electrical cables.

6. The housing according to any one of claims 4 to 5, wherein the lateral wall (48) of the bay (40) is slanted to limit the angular distance between the first and second positions.

7. The housing according to any one of claims 1 to 6, wherein the stack (50) of electrical cables is connected between the high-voltage electronics housed inside the main volume (32) and the low-voltage electronics housed inside the bay (40) at each moment of the movement of the bay.

8. The housing according to any one of claims 1 to 7, wherein the bay (40) is, at least on the side oriented toward the opening (20) when the bay is in its first position, open to access the low-voltage electronics housed in the bay.

9. The housing according to any one of claims 1 to 8, wherein the bay (40) has vents (56) in fluid communication with the air gap of the double wall of the bay (40), and the cover (16) has a plurality of slits (55) intended to come across from the vents when the housing is closed to allow air to circulate between the double wall of the bay and the outside of the housing.
